# EUROPEAN PATENT SPECIFICATION

(11) **EP 4 163 651 B1**
(45) Date of publication and mention of the grant of the patent: **10.12.2025**
(21) Application number: 21290064.1
(22) Date of filing: 08.10.2021
(51) Int. Cl.: G01R 31/12, G01R 31/00

(54) **DEVICE FOR DETECTING ELECTRICAL ARC EVENTS IN AN ELECTRICAL SYSTEM**
VORRICHTUNG ZUR ERFASSUNG VON ELEKTRISCHEN LICHTBOGENEREIGNISSEN IN EINEM ELEKTRISCHEN SYSTEM
DISPOSITIF POUR DÉTECTER DES ÉVÉNEMENTS D'ARC ÉLECTRIQUE DANS UN SYSTÈME ÉLECTRIQUE

(43) Date of publication of application: 12.04.2023
(73) Proprietor: Airbus SAS, 31707 Blagnac (FR)
(72) Inventor: Chassaigne, Didier, 31707 Blagnac (FR); Friedberger, Alois, 82024 Taufkirchen (DE)
(74) Representative: LKGLOBAL Lorenz & Kopf Patentanwalt Attorney at Law PartG mbB

(56) References cited:
- EP-A1- 2 894 451
- EP-A2- 1 970 718
- WO-A1-2020/053727
- CN-A- 106 443 390
- CN-A- 112 067 958
- US-A1- 2003 206 111
- US-A1- 2005 194 979
- US-A1- 2011 043 219
- US-A1- 2015 357 972

## Description

### Field of the invention

The invention relates to the monitoring of electrical systems. In particular, the invention relates to a device for detecting electrical arc events in an electrical system, a system comprising such a device as well as an aircraft comprising the device.

### Technical Background

Electrical systems like electrical terminals or electrical conductor lines are used in many different technical fields where the correct functioning of such systems must be monitored in order to ensure a reliable operation of the underlying electrical system. Usually, electrical cables or cable bundles are surrounded by an electrical insulator to avoid short circuits between the individual conductors of the cables. Each insulator is functional up to a certain electrical field at which a so-called breakdown occurs. This means that, for a given voltage, a minimum distance between cables needs to be maintained. Upon a failure or malfunction in the electrical system, serial electrical arcs may occur. Such problems might become more important in systems operating with high electrical power and at high voltage levels. Arranging all cables in the system with high distance to each other is often not an option due to the limited space within the systems.

EP 2 879 252 A1 and US 2016/0229357 A1 describe a raceway for fastening, guiding and/or protecting electrical cable means comprising channel modules with longitudinal channel sections. The longitudinal channel sections are movable telescopically into one another by means of complementary male element or female element means and each of said longitudinal channel sections is provided with at least one fixation bolt.

Further, WO 2020/053727 A1 discloses a device for monitoring electrical equipment of a power grid and US 2011/043219 A1 describes a diagnostic system for detecting faults in electrical wires.

### Summary of the invention

It may be seen as an object of the invention to improve the monitoring of operating conditions in an electrical system.

A device according to the features of the independent claim is provided. Further embodiments of the invention are evident from the dependent claims and from the following description.

According to an aspect of the invention, a device for detecting and/or monitoring electrical arc events in an electrical system is provided. The device comprises a patch element comprising a flexible material and including a plurality of sensors, the plurality of sensors including sensors of different sensor types. Each sensor of at least a subset of the plurality of sensors is configured to obtain a sensor measurement indicative of an electrical arc event in the electrical system. Each sensor of the subset of the plurality of sensors is configured for providing a sensor signal based on the respective sensor measurement. The device further comprises a processing unit communicatively coupled to the plurality of sensors, wherein the processing unit is configured to process the sensor signals provided by the subset of the plurality of sensors in order to obtain processed sensor signals. The processed sensor signals indicate the electrical arc event, for example to a central processing unit or network of the underlying electrical system.

Such a device enables an improved detection of any failures or malfunctions in an electrical system. In particular, it is possible with such a device to detect or monitor an electrical arc event occurring, for example, as a result of an electric breakdown which occurs if an electric insulating material like air or other essentially insulating material is subjected to such a high voltage which causes this electric insulating material to become an electrical conductor. In this case, the electrical current flows through the electric insulating material and may cause damages to the insulating material or other neighboring components of the electrical system.

In order to detect and monitor such electrical arc events and also to apply any appropriate countermeasures, the device is equipped with multiple sensors, in particular, multiple sensors being from different sensor types. Sensor types may be distinguished by the physical property which the corresponding sensor type is able to detect. For example, an optical sensor as a first sensor type may be configured to detect a light intensity, an infrared (IR) radiation and/or an ultraviolet (UV) radiation, while an acoustic sensor as a second sensor type may be configured to detect vibrations or other characteristic sounds that are associated to certain events.

Placing the plurality of sensors on one single patch element provides a compact solution such that the whole device can be easily integrated into or attached to any structural component of an electrical system where electrical arc events have to be monitored. The flexible material of the patch element can be bent or wrapped around certain components of a structure. The patch element may be in the form of or similar to a printed circuit board (PCB) on which the sensors are placed. The inventive device thus combines the benefits of printed electronics by integrating several different sensing technologies into a single monitoring patch, e.g., by integrating different sensors on a single patch element. The device may thus be a PCB including the different sensors or a flexible PCB including the different sensors. The integration of the combined sensor arrangement on such a PCB or printed electronics enables a compact solution which can be easily installed and operated with high reliability. It should be understood that the combination of sensors providing the respective measurements is able to recognize an electrical arc event. Usually, one sensor will not be sufficient to detect such an electrical arc event, however, the specific combination of sensors on the patch element provides this ability.

It should also be understood that the sensor combination of different sensor types may be such that the measurements of all sensors together can provide a reliable indication that an electrical arc event has occurred. In other words, the device may be able to provide a light measurement that is indicative of an electrical arc event, a temperature measurement that is indicative of an electrical arc event, a sound measurement that is indicative of an electrical arc event and/or a pressure measurement that is indicative of an electrical arc event. As soon as the combination of sensor measurements indicates that an electrical arc event has occurred in the vicinity of or adjacent to the sensors, this information can be provided and further processed by the processing unit.

In this manner, it is possible to detect or monitor several relevant parameters for serial electrical arcs detection with a low-cost approach, simple installation and redundancy which also increases the safety in systems where high voltages can occur. In particular, the monitoring of serial electrical arcs improves the safe operation of the underlying electrical system. The inventive device provides a reliable and cost-efficient monitoring. In addition, due to the compactness of the device, it can be easily integrated into several structural systems that must be monitored, for example terminal blocks or cable bundles.

All sensors of the plurality of sensors may be disposed on or integrated in the patch element. At least some sensors, i.e., a subset of sensors of the plurality of sensors is configured to obtain a sensor measurement indicative of an electrical arc event in the electrical system. This means that there may be enough sensors provided on or in the patch element such that the detection of an electrical arc event is possible. Having only one sensor might not be sufficient to reliably indicate the electrical arc event. This is why the patch element has a plurality of sensors, in particular sensors of different sensor types, which provides the advantage that an electrical arc event can be recognized, at least with a predetermined probability. The more reliable the sensor measurements are, the more reliable is the indication of the electrical arc event.

Each sensor of the plurality of sensors is configured for providing a sensor signal based on the respective sensor measurement, wherein the senor signal is representative for the respective sensor measurement. The processing unit communicates with the plurality of sensors, for example via a wireless and/or wired communication link. It may be possible that a portion of sensors of the plurality of sensors is coupled to the processing unit via a wired communication link and while another portion of sensors of the plurality of sensors is coupled to the processing unit via a wireless communication link.

Furthermore, the sensors transmit the sensor signals to the processing unit such that the processing unit can process the sensor signals. The sensor signals can be compared to corresponding threshold values of the respective measured physical property that must be exceeded to determine that an electrical arc event has occurred. For example, if a sufficient number of sensor signals from the different sensor types has exceeded a threshold value, the processing unit is able to assess whether or not the electrical arc event has occurred. A corresponding indication for the electrical arc event can then be made by the processing unit.

According to an embodiment, the patch element is a flexible foil and the plurality of sensors are attached to or integrated in the flexible foil.

The sensors may be disposed on a surface of the foil. In addition, a protective layer, for example also in the form of a foil, may cover the sensors to mechanically protect the sensors from environmental influences. In another example, the sensors are integrated into the flexible foil. Using a flexible foil as the patch element on which the sensors are placed facilitates mounting the device to any structural component in an electrical system. In particular, the flexible foil can be easily bent or wrapped around a corresponding component.

According to another embodiment, the plurality of sensors includes at least one of an optical sensor, a radiation sensor, an acoustic sensor, a temperature sensor, a pressure sensor, an acceleration sensor, a strain gauge, a smoke detector or any combination thereof.

For example, all or only some of the above-mentioned sensor types may be combined. The optical sensor may be configured for visible light detection, UV detection and/or IR detection. In particular, the optical sensor may provide sensor signals based on which a light intensity that is characteristic of an electrical arc event can be evaluated. Furthermore, the optical sensor may provide image data based on which a typical visual appearance of an electrical arc event, for example a light arc, can be detected. Optical waveguides arranged on the patch element may collect and transport the light or light signal to a detector which can be integrated on the patch element. This allows for optical-electrical conversion, signal processing and also wireless data transfer on the single patch element.

The radiation sensor may be a spiral antenna and may be configured for radiation detection. The acoustic sensor may be a microphone and may be configured for acoustic emission detection. The pressure sensor may be configured to detect a pressure or pressure change. The temperature sensor may be configured to detect a temperature or temperature change. The acceleration sensor may be configured to detect a movement and/or a vibration of the patch element and the strain gauge may be configured to detect a deformation of the patch element. The smoke detector can detect any smoke in the vicinity of the device since smoke can also be an indicator for an electrical arc event.

Since many different sensor measurements can be obtained to detect the presence of an electrical arc event, the inventive device may also be referred to as serial arcs multiparameter monitoring patch.

According to another embodiment, the processing unit is communicatively coupled to the plurality of sensors via a wired communication link. Additionally or alternatively, the processing unit is communicatively coupled to the plurality of sensors via a wireless communication link.

The data transfer between the electronics and the processing unit may thus be carried out via the wired or wireless communication link. In particular, the sensor signals that include the information about the measurements taken by the respective sensors can be transmitted via the communication link. A wireless communication link may further simplify the installation and reduces the number of wirings for coupling the sensors.

According to another embodiment, the processing unit is attached to or integrated in the patch element.

In this manner, a compact design can be provided, wherein all data processing is locally performed directly at the device. This means that the sensors and the processing unit may be arranged at/on the patch element. The processing unit can then communicate the processed sensor signals to a central processing network of the underlying electrical system. However, it is understood that the processing unit can also be arranged separately from the device, i.e., the processing unit is not arranged at/on the patch element, but is rather a part of a remote system.

According to another embodiment, the processing unit is configured to monitor an operating condition of the plurality of sensors.

In this manner, it can be assessed whether one or more of the plurality of sensors are operating and functioning correctly. This means that, in addition to the sensors, electronics can be added for sensor control and local data preprocessing. All these electronics may also be arranged on the patch element. Several independent physical detection principles allow for a high level of reliability and low false alarms, e.g., both false negative and false positive. Having two or more identical pieces of a certain sensor type and comparing the information of the different sensors enables self-test functionalities of the device.

One self-test functionality can be realized by placing emitters like one or more LEDs or laser diodes on the patch element and monitoring the optical sensors while operating the emitters. If two sensors, which are from the same sensor type, e.g., the two optical sensors, receive identical measurements, it can be assumed that both sensors are operating correctly. If different measurements are received, this may indicate a failure or malfunction of one of the sensors.

A further option for an active self-test is a micro heater placed next to a temperature sensor. Upon a defined heater pulse the temperature sensor response can be compared to an expected sensor behavior.

Similarly, an ultrasonic wave generator can be used to check whether the acoustic sensor, for example a microphone, detects an expected sound signal. Alternatively, an algorithm can be applied to check if the acoustic sensor provides an output which is expected due to the normal vibrations and noises at a specific mode of the underlying system in which the device is installed.

With additional electronics it is possible to generate electromagnetic waves, which can be used for a self-test of the spiral antenna functionality.

According to another embodiment, the device comprises a control unit configured for controlling the plurality of sensors based on the processed sensor signals.

The control unit may be a part of the processing unit or may be communicatively coupled to the processing unit. For example, the control unit may be configured to individually activate or deactivate one or more sensors of the plurality of sensors. In this manner, it is possible to deactivate a sensor for which a failure or malfunction has been detected, for example after carrying out one of the above-described self-test functionalities.

According to another embodiment, at least two sensors of the plurality of sensors are from the same sensor type.

This further improves the reliability of the measurements obtained by the sensors. For example, the measurements from sensors of the same sensor type can be compared to each other to provide a self-test functionality as described above. If a first and second sensor are from the same sensor type and the measurement from the first sensor deviates from that of the second sensor, then a determination can be made that one of the sensors is not operating correctly, i.e., one of the sensors is malfunctioning.

According to another embodiment, the device comprises an energy supply unit for providing electrical energy to the plurality of sensors using at least one of a wired or a wireless energy transmission.

The energy supply unit may be arranged on or in the patch element. To avoid any cabling or additional wirings, wireless energy harvesting, for example inductive energy transmission, can be applied for powering the device, in particular for powering the sensors and the processing unit. The energy supply unit can then deliver the harvested electrical energy to the sensors and the processing unit for operation. This can be supported by an energy storage unit on or in the patch element, e.g., supercapacitor or a battery. The energy storage unit may store an amount of energy provided by the energy supply unit.

Alternatively, remote powering can be utilized, e.g., through electromagnetic radiation or ultrasonic waves which are received by an energy harvesting unit arranged on the patch element. The energy harvesting unit may be a part of the energy supply unit.

A complete wireless operation, including wireless data transmission as well as wireless energy transmission, minimizes installation costs and simplifies sharing the gained sensor information without extensively impacting an installation or structure in which the inventive device is installed.

According to another embodiment, the energy supply unit is configured for providing the electrical energy to the plurality of sensors using an inductive coupling with an electrical conductor.

One approach is to utilize the power in feeder cables of the electrical system by an inductive coupling. This means that the electrical system in which the inventive device is installed usually has electrical conductors, the so-called feeder cables carrying the electric current, and the electric current in the electrical conductors can then be utilized by the energy harvesting unit of the energy supply unit via inductive coupling.

According to an aspect, a system is provided. The system may be an electrical system and comprises the inventive device as described herein. The system further comprises an electrical terminal, also referred to as terminal block, having an electrical connector for connecting two electrical conductors, wherein the electrical terminal includes a protective cover at least partially covering the electrical connector. The patch element of the inventive device is attached to the protective cover or forms at least a part of the protective cover. Each sensor of the subset of the plurality of sensors is configured to obtain a sensor measurement indicative of an electrical arc event at the electrical terminal.

The system may be integrated in an aircraft and, thus, the electrical terminal may be part of an aircraft. The electrical terminal is used to connect power cables in the aircraft, especially at section interfaces. To monitor any malfunctioning of the electrical terminal, which for example is represented by an electrical arc event adjacent the electrical terminal, the sensors provide the corresponding information for indicating this electrical arc event.

According to another embodiment, the patch element is at least partially wrapped around to the protective cover.

Since the patch element may be formed of a flexible material like polyimide or fabric, it may be shaped so as to adapt the outer contour of the protective cover. For example, the patch element may be formed as a foil. The components, i.e., the sensors and/or the processing unit can be placed on top of the foil and possibly covered by a further protection layer. Alternatively, the components can be embedded in the foil. The foil and/or any further protection layers may also be formed of polyimide.

According to an aspect, a system is provided. The system may be an electrical system and comprises the inventive device as described herein. The system further comprises at least two electrical conductors arranged next to one another. The electrical conductors may be parts of respective electrical cables or cable bundles. The patch element is arranged adjacent to the at least two electrical conductors such that each sensor of the subset of the plurality of sensors is configured to obtain a sensor measurement indicative of an electrical arc event between the at least two electrical conductors.

Again, the system may be integrated in an aircraft and, thus, the electrical conductor arrangement may be part of an aircraft. The electrical conductors are used to transfer electrical energy. Since the distance between neighboring electrical conductors may be small, a high voltage may result in an electrical arc event. This electrical arc event can then be detected with the sensor subset since the patch element, on which the sensors are located, is arranged adjacent to the at least two electrical conductors.

According to another embodiment, the at least two electrical conductors are part of a cable bundle, and the patch element is at least partially wrapped around the cable bundle.

This means that the patch element on which the sensors are located may be wrapped or wound around the cables and thus also the electrical conductors, such that the sensors are located in the immediate vicinity of the electrical conductors, where the electrical arc event might occur.

According to an aspect, an aircraft comprising the inventive device as described herein is provided.

The aircraft may be a manned or unmanned aerial vehicle. For example, the aircraft is a transport or a military aircraft. However, it should be understood that the inventive device may be integrated in all kinds of applications where the operation and functioning of an electrical system need to be monitored. Therefore, the inventive device may be integrated into all kinds of stationary platforms, such as power plants, or moving platforms, such as vehicles.

### Brief description of the drawings

The present invention will hereinafter be described in conjunction with the following drawing figures, wherein like numerals denote like elements, and wherein:
- Fig. 1: shows a device for detecting electrical arc events in an electrical system, according to an exemplary embodiment.
- Fig. 2: shows a device having a patch element wrapped around a component of an electrical system, according to an exemplary embodiment.
- Fig. 3: shows an electrical terminal, according to an exemplary embodiment.
- Fig. 4: shows a side view of a channel of an electrical terminal, according to an exemplary embodiment.
- Fig. 5: shows an electrical system having a plurality of electrical conductors, according to an exemplary embodiment.
- Fig. 6: shows an aircraft including the device of Fig. 1, according to an exemplary embodiment.

### Detailed description of exemplary embodiments

The representations and illustrations in the drawings are schematic and not to scale. A better understanding of the method and system described above may be obtained through a review of the illustrations accompanying this application together with a review of the detailed description that follows.

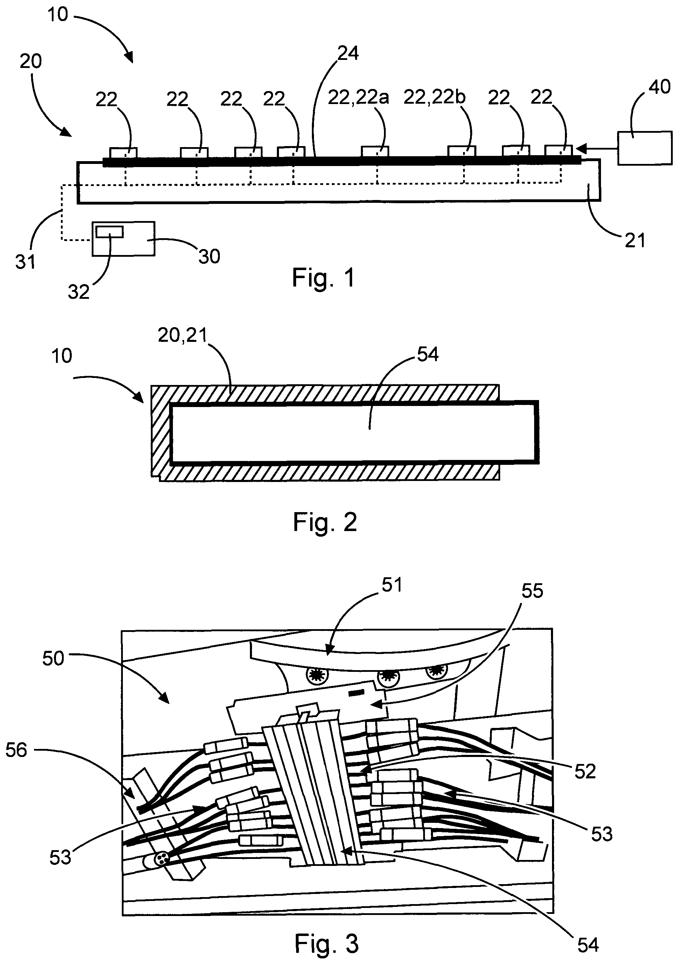

Fig. 1 shows a device 10 that is configured for detecting and/or monitoring electrical arc events in an electrical system. In particular, the device 10 may be configured to detect an electrical arc event that occurs in the vicinity of, i.e., adjacent to the device 10. The device 10 comprises a patch element 20 including a plurality of sensors 22, wherein the plurality of sensors 22 include sensors of different sensor types. Each sensor 22 of at least a subset of the plurality of sensors 22 is configured to obtain a sensor measurement indicative of an electrical arc event in the electrical system. It is noted that the sensors 22 may be configured to receive changes in the physical characteristics in the vicinity of or near the device 10. Therefore, each sensor 22 of the subset of the plurality of sensors 22 is configured for providing a sensor signal based on the respective sensor measurement. These sensor signals are then provided via a wireless or wired communication link 31 to a processing unit 30. The processing unit 30 is a part of the device 10, but can either be integrated in the patch element 20 or can be separately arranged from the patch element 20. The processing unit 30 is configured to process the sensor signals provided by the subset of the plurality of sensors 22 in order to obtain processed sensor signals, wherein the processed sensor signals indicate the electrical arc event that has occurred in the vicinity of, i.e., adjacent to the device 10.

The patch element 20 may be a flexible foil 21 and the plurality of sensors 22 are attached to or integrated in the flexible foil 21. This means that the sensors 22 may be arranged on top of the patch element 20 or foil 21 as shown in Fig. 1. However, a configuration where the sensors 22 are at least partially covered by a protective layer of material (not shown) is also contemplated herein. An interconnection 24 for mechanically coupling the sensors 22 to the patch element 20 or foil 21 is shown in Fig. 1. This interconnection 24 may be in the form of an adhesive or may comprise another mechanism for mechanically coupling the sensors 22 on the patch element 20 or foil 21.

The plurality of sensors 22 may include one or more of an optical sensor, a radiation sensor, an acoustic sensor, a temperature sensor, a pressure sensor, an acceleration sensor, a strain gauge, a smoke sensor or a combination thereof. It is possible that at least two sensors 22a, 22b of the plurality of sensors 22 are from the same sensor type. For example, both sensors 22a, 22b are optical sensors. For example, sensor 22a is a visible light sensor and sensor 22b is an optical infrared sensor.

The processing unit 30 is configured to monitor an operating condition of the plurality of sensors 22. For example, the processing unit 30 may determine a failure or malfunction of one or more of the sensors 22, for example by applying a self-test functionality on the sensors 22. The device 10 may further comprise a control unit 32 configured for controlling the plurality of sensors 22 based on the processed sensor signals. If for example a failure or malfunctioning of a particular sensor 22 has been determined by the processing unit 30, this sensor may be deactivated or measurements from this sensor 22 may be disregarded. In the example shown in Fig. 1, the control unit 32 is part of the processing unit 30, however, it is possible that the processing unit 30 and the control unit 32 are spatially separated from each other.

The device 10 may further comprise an energy supply unit 40 for providing electrical energy to the plurality of sensors 22 using at least one of a wired or a wireless energy transmission. For example, the energy supply unit 40 is configured for providing the electrical energy to the plurality of sensors 22 using an inductive coupling to a neighboring electrical conductor (not shown), which is an example of a wireless energy supply of the sensors 22. However, it is possible that some or all of the sensors 22 are supplied with energy via a wired coupling between the energy supply unit 40 and the respective sensors 22.

Fig. 2 shows a device 10, for example the device 10 as described with reference to Fig. 1, with the flexible patch element 20 wrapped around a component 54 of an electrical system. The component 54 of the electrical system may be a protective cover of an electrical terminal (not shown in Fig. 2). Such an electrical terminal will be described in more detail with reference to Fig. 3 below.

As described above, the patch element 20 may be a foil 21. Such a foil 21, which for instance is made of polyimide, is easily deformable and geometrically adaptable to an arbitrary shape of the corresponding component 54. In the example shown in Fig. 2, the component 54 has a block-like shape and the foil 21 is partially wrapped around the component 54 thereby being supported by the component 54. In this manner, the foil 21 of device 10 that supports the plurality of sensors (not shown) can be integrated into various systems of different geometries.

Fig. 3 shows an electrical system 50. The system 50 comprises an electrical terminal 51 or terminal block 51 having an electrical connector 52, i.e., a terminal lug 52, for connecting two electrical conductors 53 in the form of cables, wherein the electrical terminal 51 includes a protective cover 54 that at least partially covers the electrical connector 52. The electrical terminal 51 further includes a structure interface 55 that mechanically couples the electrical terminal 51 to the surrounding structure. The surrounding structure may be a primary or secondary structural element of a vehicle or an aircraft. The electrical terminal 51 further includes a ramp for a drip loop and an attachment point 56 for attaching the electrical conductors 53 to the surrounding structure. The electrical terminal 51 may be installed in a vehicle or an aircraft to connect power cables, which include the electrical conductors 53, at section interfaces.

The protective cover 54 of Fig. 3 may represent the component 54 of Fig. 2, wherein the electrical terminal 51 in Fig. 3 further comprises the device 10 as described with reference to Figs. 1 and 2. In such an example, the patch element 20 or foil 21 of the device 10 can be attached to the protective cover 54, for example on top, below or on both sides of the protective cover 54 of the electrical terminal 51. It is possible that the patch element 20 or foil 21 is wrapped or wound around the protective cover 54, due to the flexibility and bendability of the patch element 20 or foil 21. However, it is also possible that the patch element 20 or foil 21 itself forms the protective cover 54 or at least a part thereof. This means that the protective cover 54 of existing electrical terminals 51 may be replaced by the patch element 20 or foil 21 of the inventive device 10.

In these configurations in which the protective cover 54 comprises the patch element 20 or foil 21, the subset of the plurality of sensors 22 is configured to obtain a sensor measurement indicative of an electrical arc event at the electrical terminal 51. In particular, the sensors 22 may be arranged on the patch element 20 or foil 21 as shown in Fig. 1 such that the sensors 22 are arranged in the immediate vicinity of the electrical terminal 51. An electrical arc event at the electrical terminal 51 can thus be monitored or detected based on the sensor signals provided by the sensors 22. Therefore, the sensors 22 may be arranged with respect to the electrical conductors 53 in such a way that an electrical arc event which likely occurs at the electrical conductors 53 can be detected by the sensors 22. This may include placing the sensors 22 at most 100 cm, at most 50 cm, at most 30 cm, at most 20 cm, at most 10 cm, at most 5 cm or at most 2 cm away from the electrical conductors 53 of the electrical terminal 51 or away from the electrical connector 52 of the electrical terminal 51.

In the example where the protective cover 54 comprises the inventive device 10 including the patch element 20 or foil 21 with the sensors 22, the protective cover 54 provides two functions. The first function is to detect the electrical arc event at the electrical terminal 51. The second function is to protect the electrical connector 52 from mechanical or environmental influences.

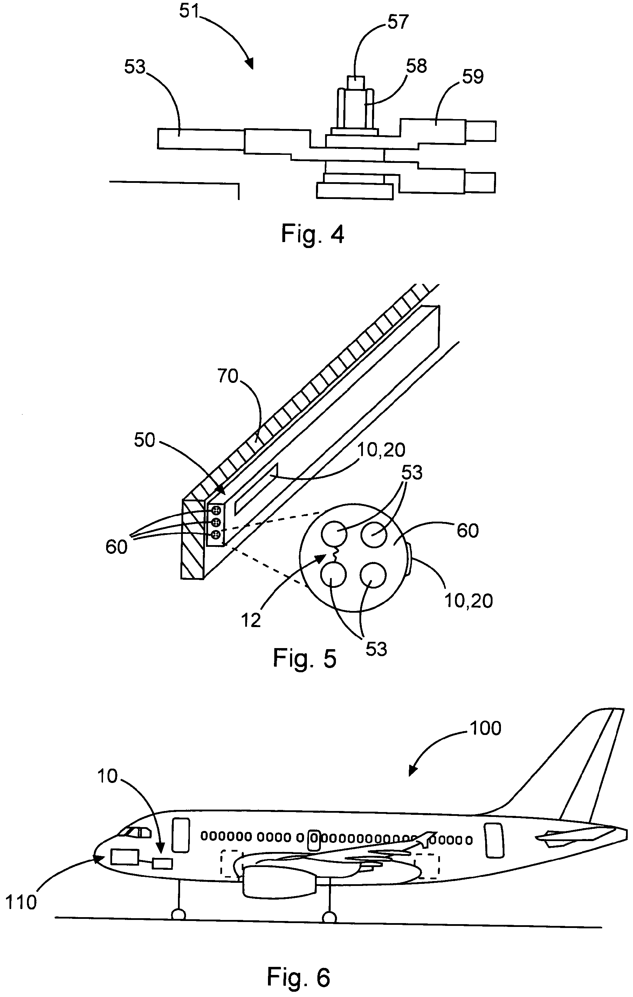

Fig. 4 shows a side view of a single channel of an electrical terminal 51. For this channel, the electrical terminal 51 comprises an electrical conductor 53 in the form of a feeder cable 53, a terminal 59, and a mounting mechanism with a terminal stud 57 and a self-locking nut 58 for electrically coupling the feeder cable 53 and the terminal 59. Such channels of an electrical terminal 51 may possibly be deteriorated by an electrical arc event between any of the electrical conductors 53 and 59 present in the electrical terminal 51. To protect the whole electrical terminal 51 from further damage, the electrical arc can be detected or monitored by the device 10 which may be attached to the electrical terminal 51 as described with reference to Figs. 1 to 3.

Fig. 5 shows an electrical system 50 having a plurality of electrical conductors 53 which are arranged in an electrical cable bundle 60. The system 50 of Fig. 5 shows three cable bundles 60, wherein each cable bundle 60 comprises four electrical conductors 53 being arranged next to one another. The device 10 with the patch element 20 or foil 21 as described with reference to Fig. 1 is arranged adjacent to the electrical conductors 53, for example on the outer surface of the cable bundle 60, such that each sensor (not shown) of the device 10 is configured to obtain a sensor measurement indicative of the electrical arc event 12 between two of the electrical conductors 53. This may include placing the sensors at most 100 cm, at most 50 cm, at most 30 cm, at most 20 cm, at most 10 cm, at most 5 cm or at most 2 cm away from the electrical conductors 53 of the cable bundle 60. In the example shown in Fig. 5, the device 10 with the patch element 20 or foil 21 including the sensors as described with reference to Fig. 1 is attached to an outer surface of the cable bundle 60. The electrical conductors 53 between which the electrical arc event 12 occurs are near enough to the sensors of the device 10 such that the electrical arc event 12 can be detected by the sensors using the combined sensor information of the plurality of sensors. As can be seen in Fig. 5, the at least two electrical conductors 53 are part of the cable bundle 60, and the patch element 20 or foil 21 is at least partially wrapped around the cable bundle 60.

The patch element 20 or foil 21 of the device 10 is optionally provided with integrated optical wave guides which can be installed on a structure, e.g., a wing spar 70 along the area where a cable bundle 60 is installed. In case of a short circuit somewhere in the cable bundle 60 or between two cable bundles 60 which may result in an electrical arc, the device 10 can detect this electrical arc by means of the sensors. The device 10 can contain additional sensors, e.g., vibration sensors to monitor abnormal movements of the bundle, for example to provide a warning that a bracket of the cable bundle 60 might be broken. In this manner, preventive maintenance is supported and simplified due to the localization of the problem. In other words, the inventive device 10 does not only recognize the electrical arc event, but also localizes it. The sensor signals may thus also include information about a location where the electrical arc event has occurred.

Fig. 6 shows an aircraft 100 including the device 10 of Fig. 1. The device may be attached to an aircraft structure, in particular a structure where an electrical arc event might occur. The processing unit 30 of the device 10 (cf. Fig. 1) is communicatively coupled to an aircraft network 110. The device 10 may particularly be connected to the aircraft network 110 by a cable through a connector. For example, the cable may follow the power cables to the secondary power distribution box (SPDB) where a computer can initiate alarm decisions.

In an example, the system 50 of Fig. 5 and/or the electrical terminal 51 of Fig. 4 may be integrated in the aircraft 100. The electrical terminal 51 of Fig. 4 may be used to connect power cables in the aircraft 100, especially at section interfaces. The system 50 of Fig. 5 may be used to supply energy to specified parts within the aircraft 100. Both the system 50 of Fig. 5 and the electrical terminal 51 of Fig. 4 may include the device as described with reference to Figs. 1 to 5 above. Therefore, any electrical arc event 12 in the electrical terminal 51 or system 50 can be detected or monitored by the sensors of the device 10. The corresponding information for indicating this electrical arc event 12 can be forwarded to the aircraft network 110 for further processing and/or for initiating an alarm condition.

## Claims

1. Device (10) for detecting electrical arc events (12) in an electrical system (50), comprising:
a plurality of sensors (22), the plurality of sensors (22) including sensors of different types;
wherein each sensor (22) of at least a subset of the plurality of sensors (22) is configured to obtain a sensor measurement indicative of an electrical arc event (12) in the electrical system (50);
wherein each sensor (22) of the subset of the plurality of sensors (22) is configured for providing a sensor signal based on the respective sensor measurement;
a processing unit (30) communicatively coupled to the plurality of sensors (22);
wherein the processing unit (30) is configured to process the sensor signals provided by the subset of the plurality of sensors (22) in order to obtain processed sensor signals, the processed sensor signals indicating the electrical arc event (12), **characterized in that** the plurality of sensors (22) are comprised by a patch element (20) that comprises a flexible material.

2. Device (10) according to claim 1,
wherein the patch element (20) is a flexible foil (21) and wherein the plurality of sensors (22) are attached to or integrated in the flexible foil (21).

3. Device (10) according to any one of the preceding claims,
wherein the plurality of sensors (22) includes at least one of an optical sensor, a radiation sensor, an acoustic sensor, a temperature sensor, a pressure sensor, an acceleration sensor, a strain gauge or a combination thereof.

4. Device (10) according to any one of the preceding claims,
wherein the processing unit (30) is communicatively coupled to the plurality of sensors (22) via a wired communication link (31); and/or
wherein the processing unit (30) is communicatively coupled to the plurality of sensors (22) via a wireless communication link (31).

5. Device (10) according to any one of the preceding claims,
wherein the processing unit (30) is attached to or integrated in the patch element (20).

6. Device (10) according to any one of the preceding claims,
wherein the processing unit (30) is configured to monitor an operating condition of the plurality of sensors (22).

7. Device (10) according to any one of the preceding claims, comprising:
a control unit (32) configured for controlling the plurality of sensors (22) based on the processed sensor signals.

8. Device (10) according to any one of the preceding claims,
wherein at least two sensors (22a, 22b) of the plurality of sensors (22) are from the same sensor type.

9. Device (10) according to any one of the preceding claims, comprising:
an energy supply unit (40) for providing electrical energy to the plurality of sensors (22) using at least one of a wired or a wireless energy transmission.

10. Device (10) according to claim 9,
wherein the energy supply unit (40) is configured for providing the electrical energy to the plurality of sensors (22) using an inductive coupling to an electrical conductor.

11. System (50), comprising:
the device (10) according to any one of the preceding claims;
an electrical terminal (51) having an electrical connector (52) for connecting two electrical conductors (53), wherein the electrical terminal (51) includes a protective cover (54) at least partially covering the electrical connector (52);
wherein the patch element (20) is attached to the protective cover (54) or forms the protective cover (54); and
wherein each sensor (22) of the subset of the plurality of sensors (22) is configured to obtain a sensor measurement indicative of an electrical arc event (12) at the electrical terminal (51).

12. System (50) according to claim 11,
wherein the patch element (20) is at least partially wrapped around the protective cover (54).

13. System (50) comprising:
the device (10) according to any one of claims 1 to 10;
at least two electrical conductors (53) arranged next to one another;
wherein the patch element (20) is arranged adjacent to the at least two electrical conductors (53) such that each sensor (22) of the subset of the plurality of sensors (22) is configured to obtain a sensor measurement indicative of an electrical arc event (12) between the at least two electrical conductors (53).

14. System (50) of claim 13,
wherein the at least two electrical conductors (53) are parts of a cable bundle (58), and wherein the patch element (20) is at least partially wrapped around the cable bundle (58).

15. Aircraft (100) comprising the device (10) according to any one of claims 1 to 10, wherein the processing unit (30) is communicatively coupled to an aircraft network (110).

## Patentansprüche

1. Vorrichtung (10) zum Detektieren von elektrischen Lichtbogenereignissen (12) in einem elektrischen System (50), umfassend:
eine Vielzahl von Sensoren (22), wobei die Vielzahl von Sensoren (22) Sensoren unterschiedlicher Typen umfasst;
wobei jeder Sensor (22) von mindestens einer Teilmenge der Vielzahl von Sensoren (22) konfiguriert ist eine Sensormessung zu erhalten, die ein elektrisches Lichtbogenereignis (12) in dem elektrischen System (50) anzeigt;
wobei jeder Sensor (22) der Teilmenge der Vielzahl von Sensoren (22) konfiguriert ist zum Bereitstellen eines Sensorsignals basierend auf der jeweiligen Sensormessung;
eine Verarbeitungseinheit (30), die kommunikativ mit der Vielzahl von Sensoren (22) gekoppelt ist;
wobei die Verarbeitungseinheit (30) konfiguriert ist, die Sensorsignale zu verarbeiten, die von der Teilmenge der Vielzahl von Sensoren (22) bereitgestellt werden, um verarbeitete Sensorsignale zu erhalten, wobei die verarbeiteten Sensorsignale das elektrische Lichtbogenereignis (12) anzeigen, **dadurch gekennzeichnet, dass** die Vielzahl von Sensoren (22) von einem Patch-Element (20) umfasst ist, das ein flexibles Material umfasst.

2. Vorrichtung (10) nach Anspruch 1,
wobei das Patch-Element (20) eine flexible Folie (21) ist und wobei die Vielzahl von Sensoren (22) an der flexiblen Folie (21) angebracht oder in diese integriert ist.

3. Vorrichtung (10) nach einem der vorhergehenden Ansprüche,
wobei die Vielzahl von Sensoren (22) mindestens einen von einem optischen Sensor, einem Strahlungssensor, einem akustischen Sensor, einem Temperatursensor, einem Drucksensor, einem Beschleunigungssensor, einem Dehnungsmessstreifen oder eine Kombination davon umfasst.

4. Vorrichtung (10) nach einem der vorhergehenden Ansprüche,
wobei die Verarbeitungseinheit (30) über eine drahtgebundene Kommunikationsverbindung (31) kommunikativ mit der Vielzahl von Sensoren (22) gekoppelt ist; und/oder
wobei die Verarbeitungseinheit (30) über eine drahtlose Kommunikationsverbindung (31) kommunikativ mit der Vielzahl von Sensoren (22) gekoppelt ist.

5. Vorrichtung (10) nach einem der vorhergehenden Ansprüche,
wobei die Verarbeitungseinheit (30) an dem Patch-Element (20) angebracht oder in dieses integriert ist.

6. Vorrichtung (10) nach einem der vorhergehenden Ansprüche,
wobei die Verarbeitungseinheit (30) konfiguriert ist, einen Betriebszustand der Vielzahl von Sensoren (22) zu überwachen.

7. Vorrichtung (10) nach einem der vorhergehenden Ansprüche, umfassend:
eine Steuereinheit (32), konfiguriert zum Steuern der Vielzahl von Sensoren (22) basierend auf den verarbeiteten Sensorsignalen.

8. Vorrichtung (10) nach einem der vorhergehenden Ansprüche,
wobei mindestens zwei Sensoren (22a, 22b) der Vielzahl von Sensoren (22) vom gleichen Sensortyp sind.

9. Vorrichtung (10) nach einem der vorhergehenden Ansprüche, umfassend:
eine Energieversorgungseinheit (40) zum Bereitstellen von elektrischer Energie an die Vielzahl von Sensoren (22) unter Verwendung von mindestens einer von einer drahtgebundenen oder einer drahtlosen Energieübertragung.

10. Vorrichtung (10) nach Anspruch 9,
wobei die Energieversorgungseinheit (40) konfiguriert ist zum Bereitstellen der elektrischen Energie an die Vielzahl von Sensoren (22) unter Verwendung einer induktiven Kopplung an einen elektrischen Leiter.

11. System (50), umfassend:
die Vorrichtung (10) nach einem der vorhergehenden Ansprüche;
einen elektrischen Anschluss (51) mit einem elektrischen Verbinder (52) zum Verbinden von zwei elektrischen Leitern (53), wobei der elektrische Anschluss (51) eine Schutzabdeckung (54) umfasst, die den elektrischen Verbinder (52) mindestens teilweise abdeckt;
wobei das Patch-Element (20) an der Schutzabdeckung (54) angebracht ist oder die Schutzabdeckung (54) bildet; und
wobei jeder Sensor (22) der Teilmenge der Vielzahl von Sensoren (22) konfiguriert ist, eine Sensormessung zu erhalten, die ein elektrisches Lichtbogenereignis (12) an dem elektrischen Anschluss (51) anzeigt.

12. System (50) nach Anspruch 11,
wobei das Patch-Element (20) mindestens teilweise um die Schutzabdeckung (54) herumgewickelt ist.

13. System (50), umfassend:
die Vorrichtung (10) nach einem der Ansprüche 1 bis 10;
mindestens zwei elektrische Leiter (53), die nebeneinander angeordnet sind;
wobei das Patch-Element (20) benachbart zu den mindestens zwei elektrischen Leitern (53) angeordnet ist, sodass jeder Sensor (22) der Teilmenge der Vielzahl von Sensoren (22) konfiguriert ist, eine Sensormessung zu erhalten, die ein elektrisches Lichtbogenereignis (12) zwischen den mindestens zwei elektrischen Leitern (53) anzeigt.

14. System (50) nach Anspruch 13,
wobei die mindestens zwei elektrischen Leiter (53) Teile eines Kabelbündels (58) sind, und wobei das Patch-Element (20) mindestens teilweise um das Kabelbündel (58) herumgewickelt ist.

15. Flugzeug (100), umfassend die Vorrichtung (10) nach einem der Ansprüche 1 bis 10, wobei die Verarbeitungseinheit (30) kommunikativ mit einem Flugzeugnetzwerk (110) gekoppelt ist.

## Revendications

1. Dispositif (10) pour détecter des événements d'arc électrique (12) dans un système électrique (50), comprenant:
une pluralité de capteurs (22), la pluralité de capteurs (22) incluant des capteurs de différents types;
dans lequel chaque capteur (22) d'au moins un sous-ensemble de la pluralité de capteurs (22) est configuré pour obtenir une mesure de capteur indicative d'un événement d'arc électrique (12) dans le système électrique (50);
dans lequel chaque capteur (22) du sous-ensemble de la pluralité de capteurs (22) est configuré pour fournir un signal de capteur sur la base de la mesure de capteur respective;
une unité de traitement (30) couplée en communication à la pluralité de capteurs (22);
dans lequel l'unité de traitement (30) est configurée pour traiter les signaux de capteur fournis par le sous-ensemble de la pluralité de capteurs (22) afin d'obtenir des signaux de capteur traités, les signaux de capteur traités indiquant l'événement d'arc électrique (12), **caractérisé en ce qu'**un élément de patch (20), qui comprend un matériau flexible, comprend la pluralité de capteurs (22).

2. Dispositif (10) selon la revendication 1,
dans lequel l'élément de patch (20) est une feuille flexible (21) et dans lequel la pluralité de capteurs (22) sont fixés à ou intégrés dans la feuille flexible (21).

3. Dispositif (10) selon l'une quelconque des revendications précédentes,
dans lequel la pluralité de capteurs (22) inclut au moins l'un parmi un capteur optique, un capteur de rayonnement, un capteur acoustique, un capteur de température, un capteur de pression, un capteur d'accélération, une jauge de contrainte ou une combinaison de ceux-ci.

4. Dispositif (10) selon l'une quelconque des revendications précédentes,
dans lequel l'unité de traitement (30) est couplée en communication à la pluralité de capteurs (22) via une liaison de communication filaire (31); et/ou
dans lequel l'unité de traitement (30) est couplée en communication à la pluralité de capteurs (22) via une liaison de communication sans fil (31).

5. Dispositif (10) selon l'une quelconque des revendications précédentes,
dans lequel l'unité de traitement (30) est fixée à ou intégrée dans l'élément de patch (20).

6. Dispositif (10) selon l'une quelconque des revendications précédentes,
dans lequel l'unité de traitement (30) est configurée pour surveiller une condition de fonctionnement de la pluralité de capteurs (22).

7. Dispositif (10) selon l'une quelconque des revendications précédentes, comprenant:
une unité de commande (32) configurée pour commander la pluralité de capteurs (22) sur la base des signaux de capteur traités.

8. Dispositif (10) selon l'une quelconque des revendications précédentes,
dans lequel au moins deux capteurs (22a, 22b) de la pluralité de capteurs (22) proviennent du même type de capteur.

9. Dispositif (10) selon l'une quelconque des revendications précédentes, comprenant:
une unité d'alimentation en énergie (40) pour fournir de l'énergie électrique à la pluralité de capteurs (22) en utilisant au moins l'une d'une transmission d'énergie filaire ou sans fil.

10. Dispositif (10) selon la revendication 9,
dans lequel l'unité d'alimentation en énergie (40) est configurée pour fournir l'énergie électrique à la pluralité de capteurs (22) en utilisant un couplage inductif à un conducteur électrique.

11. Système (50), comprenant :
le dispositif (10) selon l'une quelconque des revendications précédentes;
une borne électrique (51) ayant un connecteur électrique (52) pour connecter deux conducteurs électriques (53), dans lequel la borne électrique (51) inclut un couvercle de protection (54) recouvrant au moins partiellement le connecteur électrique (52);
dans lequel l'élément de patch (20) est fixé au couvercle de protection (54) ou forme le couvercle de protection (54); et
dans lequel chaque capteur (22) du sous-ensemble de la pluralité de capteurs (22) est configuré pour obtenir une mesure de capteur indicative d'un événement d'arc électrique (12) au niveau de la borne électrique (51).

12. Système (50) selon la revendication 11,
dans lequel l'élément de patch (20) est au moins partiellement enroulé autour du couvercle de protection (54).

13. Système (50) comprenant:
le dispositif (10) selon l'une quelconque des revendications 1 à 10;
au moins deux conducteurs électriques (53) agencés l'un à côté de l'autre;
dans lequel l'élément de patch (20) est agencé de manière adjacente aux au moins deux conducteurs électriques (53) de sorte que chaque capteur (22) du sous-ensemble de la pluralité de capteurs (22) est configuré pour obtenir une mesure de capteur indicative d'un événement d'arc électrique (12) entre les au moins deux conducteurs électriques (53).

14. Système (50) selon la revendication 13,
dans lequel les au moins deux conducteurs électriques (53) font partie d'un faisceau de câbles (58), et dans lequel l'élément de patch (20) est au moins partiellement enroulé autour du faisceau de câbles (58).

15. Aéronef (100) comprenant le dispositif (10) selon l'une quelconque des revendications 1 à 10, dans lequel l'unité de traitement (30) est couplée en communication à un réseau d'aéronef (110).
